# EUROPEAN PATENT APPLICATION

(11) **EP 4 723 175 A1**
(43) Date of publication of application: **08.04.2026**
(21) Application number: 24814490.9
(22) Date of filing: 29.05.2024
(51) Int. Cl.: H01L 29/06

(54) **POWER SEMICONDUCTOR DEVICE AND PREPARATION METHOD THEREFOR**

(30) Priority: 31.05.2023 CN 202310639333
(71) Applicant: Sichain Semiconductors (Ningbo) Co., Ltd., Ningbo, Zhejiang 315336 (CN)
(72) Inventor: SHI, Wenhua, Hangzhou Bay New District Ningbo, Zhejiang 315336 (CN)
(74) Representative: Elzaburu S.L.P.
(86) International application number: PCT/CN2024/096093
(87) International publication number: WO 2024/245293

(57) **Abstract**

A power semiconductor device and a preparation method therefor. The power semiconductor device comprises: a first lateral current spreading layer (120), which is located on the surface of the side of a drift layer (110) facing away from a semiconductor substrate layer (100), wherein the conductivity type of the first lateral current spreading layer (120) is the same as the conductivity type of the drift layer (110), and the doping concentration of the first lateral current spreading layer (120) is greater than the doping concentration of the drift layer (110); and a device layer (130), which is located on the surface of the side of the first lateral current spreading layer (120) facing away from the drift layer (110). The device layer (130) comprises: a plurality of active doped regions (1302), which are transversely arranged at intervals; and second lateral current spreading layers (1301), which are located between the active doping regions (1302) and part of the first lateral current spreading layer (120), without overlapping projections from the second lateral current spreading layer (1301) and the device layer between adjacent active doped regions (1302) in a direction perpendicular to a surface of the semiconductor substrate layer (100), the conductivity type of the second lateral current spreading layers (1301) is the same as the conductivity type of the first lateral current spreading layer (120), and the doping concentration of the second lateral current spreading layers (1301) is greater than the doping concentration of the drift layer (110). The power semiconductor device takes both low specific on-resistance and high reliability into consideration.

## Description

### Cross-reference to Related Applications

The application claims the priority of Chinese patent application No. 202310639333.8, entitled "Power Semiconductor Device and Preparation Method Thereof" and filed on May 31, 2023, the entirety of which is incorporated herein by reference.

### Technical Field

The present disclosure relates to the field of semiconductor technology, and in particular to a power semiconductor device and a preparation method thereof.

### Background

As unipolar power switching devices, SiC-based power MOSFETs (Metal-Oxide-Semiconductor Field-Effect Transistors) plays a pivotal role in power conversion systems for applications such as power supplies and energy processing. Compared to conventional Si-based power devices, SiC-based power devices offer higher breakdown voltage, lower energy loss, faster switching frequency and higher operating temperature, while remaining nearly fully compatible with existing Si-based fabrication processes. These advantages have driven intense market demand. Currently, the key parameter limiting further cost reduction and performance improvement of SiC-based power MOSFETs is the specific on-resistance (i.e., conduction resistance per unit area) of the device during operation, which is composed of multiple distributed resistances in series, with different proportions of each part. Among these, the channel resistance, JFET region resistance, and drift region resistance contribute the most significantly. However, due to the poor quality of gate oxides on SiC substrates and the reliability risks associated with increasing the doping concentration of JFET regions to reduce JFET resistance, it is challenging to achieve both low specific on-resistance and high reliability simultaneously.

### Summary

Therefore, the technical problem to be solved by the disclosure is to overcome the limitations in the prior art that it is difficult to achieve both low specific on-resistance and high reliability. To solve the existing problems, embodiments of the present disclosure provide a power semiconductor device and a preparation method thereof.

According to one aspect of the disclosure, a power semiconductor device is provided, which may include a semiconductor substrate layer; a drift layer disposed on a side of the semiconductor substrate layer; a first lateral current spreading layer disposed on a surface of the drift layer away from the semiconductor substrate layer, the first lateral current spreading layer having a same conductivity type as the drift layer and a higher doping concentration than the drift layer; and a device layer disposed on a surface of the first lateral current spreading layer away from the drift layer. Herein, the device layer may include a plurality of active doped regions spaced laterally, and a second lateral current spreading layer disposed between the active doped regions and portions of the first lateral current spreading layer, without overlapping projections from the second lateral current spreading layer and the device layer between adjacent active doped regions in a direction perpendicular to a surface of the semiconductor substrate layer, and the second lateral current spreading layer may have a same conductivity type as the first lateral current spreading layer and a higher doping concentration than the drift layer.

Optionally, the doping concentration of the first lateral current spreading layer may be lower than the doping concentration of the second lateral current spreading layer, or alternatively, the doping concentration of the first lateral current spreading layer may be higher than or equal to the doping concentration of the second lateral current spreading layer.

Optionally, the doping concentration of the first lateral current spreading layer may range from 0.01 to 1 times the doping concentration of the second lateral current spreading layer.

Optionally, the doping concentration of the first lateral current spreading layer may range from 2 to 5000 times a doping concentration of the drift layer, and the doping concentration of the second lateral current spreading layer may range from 2 to 5000 times the doping concentration of the drift layer.

Optionally, the second lateral current spreading layer may have a thickness less than a thickness of the first lateral current spreading layer, or alternatively, the thickness of the second lateral current spreading layer may be greater than or equal to the thickness of the first lateral current spreading layer.

Optionally, the thickness of the second lateral current spreading layer may range from 0.2 to 5 times the thickness of the first lateral current spreading layer.

Optionally, the thickness of the first lateral current spreading layer may range from 0.1 µm to 10 µm.

Optionally, the thickness of the second lateral current spreading layer may range from 0.1 µm to 10 µm.

Optionally, the first lateral current spreading layer may have a plurality of first lateral current sub-spreading layers in a through-thickness direction of the first lateral current spreading layer.

Optionally, the first lateral current sub-spreading layers may exhibit a progressive increase in doping concentration along a direction from a side of the first lateral current sub-spreading layers away from the semiconductor substrate layer to a side of the first lateral current sub-spreading layers towards the semiconductor substrate layer.

Optionally, the first lateral current sub-spreading layers may exhibit a progressive decrease in thickness along a direction from the side of the first lateral current sub-spreading layers away from the semiconductor substrate layer to the side of the first lateral current sub-spreading layers towards the semiconductor substrate layer.

Optionally, the second lateral current spreading layer may have a plurality of second lateral current sub-spreading layers in a through-thickness direction of the second lateral current spreading layer,

Optionally, the second lateral current sub-spreading layers may exhibit a progressive decrease in doping concentration along a direction from a side of the second lateral current sub-spreading layers away from the semiconductor substrate layer to a side of the second lateral current sub-spreading layers towards the semiconductor substrate layer.

Optionally, the second lateral current sub-spreading layers may exhibit a progressive decrease in thickness along a direction from the side of the second lateral current sub-spreading layers away from the semiconductor substrate layer to the side of the second lateral current sub-spreading layers towards the semiconductor substrate layer.

Optionally, the power semiconductor device may be configured as a vertical metal-oxide-semiconductor field-effect transistor (MOSFET). Herein the power semiconductor device may further include a gate structure flanked by the active doped regions serving as well regions, and a source region disposed within each of the well regions, the source region has a same conductivity type as the drift layer. The gate structure may be disposed on an upper surface of a portion of the device layer, or alternatively, the gate structure may be disposed in the device layer between adjacent active doped regions and between adjacent second lateral current spreading layers.

Optionally, the power semiconductor device may be configured as an insulated-gate bipolar transistor (IGBT). Herein, the active doped regions may serve as well regions. Herein, the power semiconductor device may further include an emitter region disposed within each of the well regions, the emitter region has a same conductivity type as the drift layer.

According to another aspect of the disclosure, a method of preparing a power semiconductor device is provided, which may include providing a semiconductor substrate layer; and forming a drift layer, a first lateral current spreading layer and a device layer stacked in a bottom-to-top configuration on the semiconductor substrate layer, where the first lateral current spreading layer may have a same conductivity type as the drift layer and a higher doping concentration than the drift layer, The device layer may include a plurality of active doped regions spaced laterally; and a second lateral current spreading layer disposed between the active doped regions and portions of the first lateral current spreading layer, without overlapping projections from the second lateral current spreading layer and the device layer between adjacent active doped regions in a direction perpendicular to a surface of the semiconductor substrate layer, where the second lateral current spreading layer may have a same conductivity type as the first lateral current spreading layer and a higher doping concentration than the drift layer.

Optionally, the step of forming the drift layer, the first lateral current spreading layer and the device layer stacked in a bottom-to-top configuration on the semiconductor substrate layer may include forming the drift layer, the first lateral current spreading layer and an initial device layer stacked in a bottom-to-top configuration on the semiconductor substrate layer; forming the plurality of active doped regions spaced laterally in partial regions of the initial device layer; and forming the second lateral current spreading layer in the initial device layer between the active doped regions and portions of the first lateral current spreading layer, so that the initial device layer constitutes the device layer.

Optionally, the method may further include forming a mask layer on a surface of a portion of the initial device layer before formation of the active doped regions; forming the active doped regions in the initial device layer by using the mask layer as mask; forming spacers on sidewall surfaces of the mask layer after formation of the active doped regions in the initial device layer by using the mask layer as mask, where the spacers may cover partial surfaces of the active doped regions; forming the second lateral current spreading layer between the active doped regions and the portions of the first lateral current spreading layer by using the spacers and the mask layer as mask; and removing the mask layer and the spacers after formation of the second lateral current spreading layer.

Optionally, the active doped regions may serve as well regions. Herein, the method may further include, before removal of the mask layer and the spacers, forming a source region within each of the active doped regions by using the spacers and the mask layer as mask.

Optionally, each of the spacers may have a width ranging from 0.1 µm to 2 µm.

Optionally, the step of forming the drift layer, the first lateral current spreading layer and the initial device layer stacked in a bottom-to-top configuration on the semiconductor substrate layer may include epitaxially growing the drift layer on the semiconductor substrate layer; epitaxially growing the first lateral current spreading layer on a surface of the drift layer away from the semiconductor substrate layer; and epitaxially growing the initial device layer on a surface of the first lateral current spreading layer away from the drift layer. Alternatively, the step of forming the drift layer, the first lateral current spreading layer and the initial device layer stacked in a bottom-to-top configuration on the semiconductor substrate layer may include epitaxially growing an initial drift layer on the semiconductor substrate layer; forming the first lateral current spreading layer by ion implantation into a partial thickness of the initial drift layer, where the initial drift layer below the first lateral current spreading layer may constitute the drift layer; and epitaxially growing the initial device layer on a surface of the first lateral current spreading layer away from the drift layer. Alternatively, the step of forming the drift layer, the first lateral current spreading layer and the initial device layer stacked in a bottom-to-top configuration on the semiconductor substrate layer may include epitaxially growing an initial drift layer on the semiconductor substrate layer; forming a first initial lateral current spreading layer by ion implantation into a partial thickness of the initial drift layer; and forming the initial device layer by ion implantation into a partial thickness of the first initial lateral current spreading layer, where the first initial lateral current spreading layer below the initial device layer may constitute the first lateral current spreading layer, and the initial drift layer below the first lateral current spreading layer may constitute the drift layer. Alternatively, the step of forming the drift layer, the first lateral current spreading layer and the initial device layer stacked in a bottom-to-top configuration on the semiconductor substrate layer may include epitaxially growing the drift layer on the semiconductor substrate layer; epitaxially growing a first initial lateral current spreading layer on a side of the drift layer away from the semiconductor substrate layer; and forming the initial device layer by ion implantation into a partial thickness of the first initial lateral current spreading layer, where the first initial lateral current spreading layer below the initial device layer may constitute the first lateral current spreading layer.

The solutions provided by the disclosure will offer the advantages described below.

By utilizing the power semiconductor device provided by the solutions of the disclosure, during forward conduction, current flows along the device layer at the edge of the active doped regions and adjacent to the active doped regions to the second lateral current spreading layer at the bottom of the active doped regions and adjacent to the active doped regions, and then conducts towards the first lateral current spreading layer and the semiconductor substrate layer. Since the second lateral current spreading layer is arranged at the bottom of the active doped regions, and the doping concentration of the second lateral current spreading layer is higher than that of the drift layer, the width of a depletion layer formed by the active doped regions and the second lateral current spreading layer is reduced. Such a depletion layer is partially formed in the second lateral current spreading layer, while the area below the depletion layer in the second lateral current spreading layer has a relatively higher doping concentration. As a result, current can quickly spread from the edge of the active doped regions into the second lateral current spreading layer, thereby improving forward conduction characteristics, and facilitating a reduction in forward conduction resistance. Due to the presence of the first lateral current spreading layer, the first lateral current spreading layer has a higher doping concentration than the drift layer, it can further distribute the current flowing through the second lateral current spreading layer, making the current distribution more uniform. This will maximize the compensation for current crowding at the top of the second lateral current spreading layer with interval distribution, contributing to the reduction of forward on-resistance, and effectively lowering specific on-resistance. Since the second lateral current spreading layer and the device layer between adjacent active doped regions exhibit no overlapping projections in the direction perpendicular to the surface of the semiconductor substrate layer, it is helpful to reduce the influence of the second lateral current spreading layer on the electric field at the surface of the device layer between adjacent active doped regions. Because the distance from the first lateral current spreading layer to the surface of the device layer is greater than the distance from the second lateral current spreading layer to the surface of the device layer, the influence of the first lateral current spreading layer on the electric field at the surface of the device layer between adjacent active doped regions is reduced, thereby suppressing the reduction of reverse breakdown voltage. This will improve reliability.

### Brief Description of the Drawings

To clarify the embodiments of the disclosure or technical solutions in the prior art, the accompanying drawings required for describing the embodiments or the prior art will be briefly introduced below. Obviously, the drawings in the following description merely represent some embodiments of the disclosure. For those of ordinary skill in the art, other illustrations may be derived from these illustrations without creative effort.
Figure 1 is a schematic structural diagram illustrating a power semiconductor device according to an embodiment of the disclosure;
Figure 2 is a schematic structural diagram illustrating a power semiconductor device according to another embodiment of the disclosure;
Figures 3 to 11 are schematic structural diagrams illustrating a manufacturing process of a power semiconductor device according to an embodiment of the disclosure; and
Figure 12 is a schematic structural diagram illustrating a manufacturing process of a power semiconductor device according to another embodiment of the disclosure.

### Detailed Description

The technical solutions of the disclosure will be clearly described in details in conjunction with the accompanying drawings. Obviously, the described embodiments represent non-limiting embodiments of the disclosure, rather than all possible embodiments. Starting from the embodiments of the disclosure, any other embodiment obtained by those of ordinary skill in the art without creative efforts shall fall within the scope of the disclosure.

In the description of the disclosure, it shall be understood that directional and positional terms such as "center", "upper", "lower", "left", "right", "vertical", "horizontal", "inner", "outer" are based on the orientations or positional relationships shown in the accompanying drawings. These terms are used solely to facilitate and simplify the description and do not indicate or imply that any referenced apparatus or element must have a specific orientation or be constructed/operated in a specific orientation. Therefore, these terms should not be interpreted as limiting the disclosure. In addition, terms such as "first", "second" and "third" are used merely for descriptive purposes and should not be interpreted as indicating or implying relative importance.

In the description of the disclosure, it should be noted that, unless otherwise expressly specified and defined, terms such as "mounted", "connected" and "connection" should be interpreted broadly. For example, a "connection" may be a fixed connection, a detachable connection, or an integral connection; it may be a mechanical connection or an electrical connection; and it may be direct connection, or an indirect connection through an intermediate medium, including internal communication between two components. For those of ordinary skill in the art, the specific meanings of these terms in the disclosure may be understood on a case-by-case basis.

Furthermore, the technical features involved in various implementations of the disclosure described below may be combined with each other, provided that no conflict arises between them.

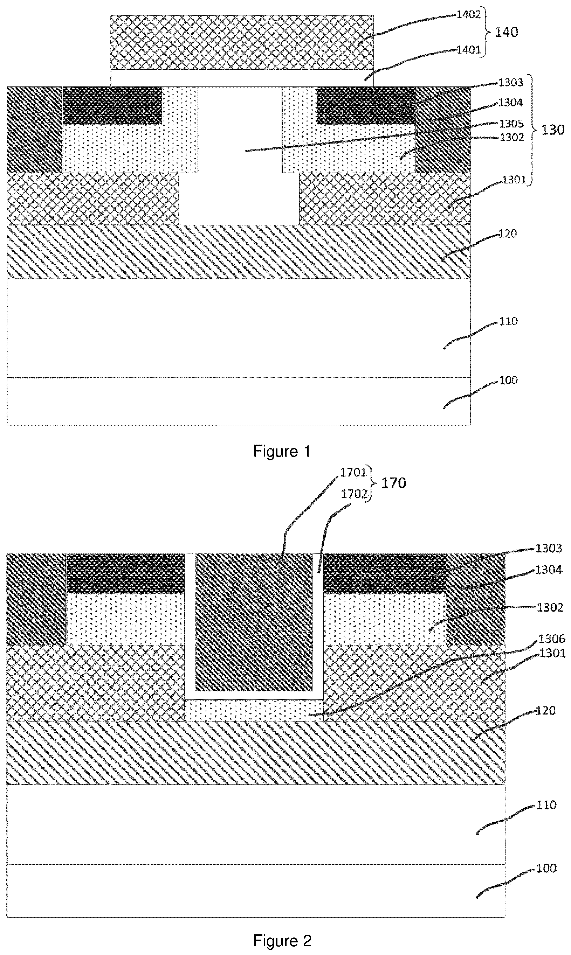

An embodiment of the disclosure provides a power semiconductor device. As shown in figure 1, the power semiconductor device includes the following layers.

A semiconductor substrate layer 100 is provided.

A drift layer 110 is disposed on a side of the semiconductor substrate layer 100.

A first lateral current spreading layer 120 is disposed on a surface of the drift layer 110 away from the semiconductor substrate layer 100. The first lateral current spreading layer 120 has a same conductivity type as the drift layer 110 but a higher doping concentration than the drift layer110.

A device layer 130 is disposed on a surface of the first lateral current spreading layer 120 away from the drift layer 110. The device layer 130 includes a plurality of laterally spaced active doped regions 1302 and a second lateral current spreading layer 1301 disposed between the active doped regions 1302 and portions of the first lateral current spreading layer 120. The second lateral current spreading layer 1301 and the device layer 130 between adjacent active doped regions 1302 exhibit no overlapping projections in a direction perpendicular to a surface of the semiconductor substrate layer 100. The second lateral current spreading layer 1301 shares a same conductivity type as the first lateral current spreading layer 120 and the second lateral current spreading layer 1301 has a higher doping concentration than the drift layer 110.

In the embodiment, during forward conduction, current flows along the device layer at the edge of the active doped regions and adjacent to the active doped regions to the second lateral current spreading layer at the bottom of the active doped regions and adjacent to the active doped regions, and then conducts towards the first lateral current spreading layer and the semiconductor substrate layer. Since the second lateral current spreading layer is arranged at the bottom of the active doped regions, and the doping concentration of the second lateral current spreading layer is higher than that of the drift layer, the width of a depletion layer formed by the active doped regions and the second lateral current spreading layer is reduced. Such a depletion layer is partially formed in the second lateral current spreading layer, while the area below the depletion layer in the second lateral current spreading layer has a relatively higher doping concentration. As a result, current can quickly spread from the edge of the active doped regions into the second lateral current spreading layer, thereby improving forward conduction characteristics, and facilitating a reduction in forward conduction resistance. Due to the presence of the first lateral current spreading layer, which has a higher doping concentration than the drift layer, it can further distribute the current flowing through the second lateral current spreading layer, making the current distribution more uniform. This will maximize the compensation for current crowding at the top of the second lateral current spreading layer with interval distribution, contributing to the reduction of forward on-resistance, and effectively lowering specific on-resistance. Since the second lateral current spreading layer and the device layer between adjacent active doped regions exhibit no overlapping projections in the direction perpendicular to the surface of the semiconductor substrate layer, it is helpful to reduce the influence of the second lateral current spreading layer on the electric field at the surface of the device layer between adjacent active doped regions. Because the distance from the first lateral current spreading layer to the surface of the device layer is greater than the distance from the second lateral current spreading layer to the surface of the device layer, the first lateral current spreading layer has no significant influence on the electric field at the surface of the device layer between adjacent active doped regions, thereby suppressing the reduction of reverse breakdown voltage. This arrangement will improve reliability.

As shown in the sectional view of Figure 1, the second lateral current spreading layer 1301 does not extend below the region between adjacent active doped regions 1302. In other words, the second lateral current spreading layer 1301 does not extend to a position that is directly opposite to the region between adjacent active doped regions 1302 in the direction perpendicular to the surface of the semiconductor substrate layer 100.

In one embodiment, the doping concentration of the first lateral current spreading layer 120 is lower than that of the second lateral current spreading layer 1301. This configuration provides the technical benefit that the second lateral current spreading layer 1301 has a higher doping concentration than the first lateral current spreading layer 120, so that the higher-doped second lateral current spreading layer 1301 will contribute to reducing specific on-resistance. The second lateral current spreading layer 1301 with a higher doping concentration is positioned below the active doped regions. In other words, the second lateral current spreading layer 1301 is positioned on the side of the active doped regions 1302 facing the semiconductor substrate layer 100, which will reduce the influence of the second lateral current spreading layer 1301 on the electric field at the surface of the device layer between adjacent active doped regions, thereby suppressing problems such as breakdown voltage degradation. Meanwhile, the first lateral current spreading layer 120 has a relatively lower doping concentration. Since the first lateral current spreading layer 120 is positioned below the region between adjacent active doped regions, the reduced doping concentration of the first lateral current spreading layer 120 will avoid intensifying the electric field at the surface of the device layer. Moreover, due to greater distance from the first lateral current spreading layer 120 to the surface of the device layer, the first lateral current spreading layer 120 further reduces its influence on the electric field at the surface of the device layer between adjacent active doped regions.

In one embodiment, the doping concentration of the first lateral current spreading layer 120 ranges from 0.01 to 1 times, for example, 0.01, 0.02, 0.05, 0.08, 0.1, 0.5, 0.8 or 1 times, the doping concentration of the second lateral current spreading layer 1301.

In one embodiment, the doping concentration of the first lateral current spreading layer 120 ranges from 2 to 5000 times, for example, 2, 10, 100, 500, 1000, 2000 or 5000 times, the doping concentration of the drift layer 110. The doping concentration of the second lateral current spreading layer 1301 ranges from 2 to 5000 times, for example, 2, 10, 100, 500, 1000, 2000 or 5000 times, the doping concentration of the drift layer 110.

In other embodiments, the doping concentration of the first lateral current spreading layer is higher than or equal to the doping concentration of the second lateral current spreading layer.

In one embodiment, the second lateral current spreading layer 1301 has a thickness less than that of the first lateral current spreading layer 120. This configuration provides the technical benefit that the thinner second lateral current spreading layer 1301 helps improve reverse breakdown voltage, and decreases the distance from the first lateral current spreading layer 120 to the bottom surface of the active doped regions, enabling faster current spreading and lower specific on-resistance. Additionally, the thicker first lateral current spreading layer 120, when combined with relatively lower doping concentration of the first lateral current spreading layer 120 , can further enhance the positive effect on reverse breakdown voltage, thereby increasing the breakdown voltage performance.

In one embodiment, the second lateral current spreading layer 1301 has a through-thickness direction perpendicular to the surface of the semiconductor substrate layer 100. In other words, the through-thickness direction of the second lateral current spreading layer 1301 is parallel to the direction from the side of the second lateral current spreading layer 1301 away from the semiconductor substrate layer 100 to the side of the second lateral current spreading layer 1301 towards the semiconductor substrate layer 100.

It should be noted that, in other embodiments, the thickness of the second lateral current spreading layer is less than or equal to the thickness of the first lateral current spreading layer.

In one embodiment, the thickness of the second lateral current spreading layer 1301 ranges from 0.2 to 5 times, for example, 0.2, 0.5, 0.8, 1, 2, 3, 4 or 5 times, the thickness of the first lateral current spreading layer 120.

In one embodiment, the thickness of the first lateral current spreading layer 120 ranges from 0.1µm to 10 µm. In one embodiment, the thickness of the second lateral current spreading layer 1301 ranges from 0.1 µm to 10 µm.

In one embodiment, the first lateral current spreading layer 120 has a through-thickness direction perpendicular to the surface of the semiconductor substrate layer 100. In other words, the through-thickness direction of the first lateral current spreading layer 120 is parallel to the direction from the side of the first lateral current spreading layer 120 away from the semiconductor substrate layer 100 to the side of the first lateral current spreading layer 120 towards the semiconductor substrate layer 100.

In one embodiment, the doping concentration of the first lateral current spreading layer 120 is lower than the doping concentration of the second lateral current spreading layer 1301, and the thickness of the second lateral current spreading layer 1301 is less than the thickness of the first lateral current spreading layer.

In the embodiment, the first lateral current spreading layer 120 is a single-layer structure, and the second lateral current spreading layer 1301 is a single-layer structure.

In other embodiments, the first lateral current spreading layer 120 has a plurality of first lateral current sub-spreading layers in the through-thickness direction of the first lateral current spreading layer 120, enabling a zoned doping concentration distribution in the second lateral current spreading layer 120. Preferably, the first lateral current sub-spreading layers exhibit a progressive increase in doping concentration along a direction from a side of the first lateral current sub-spreading layers away from the semiconductor substrate layer to a side of the first lateral current sub-spreading layers towards the semiconductor substrate layer. As illustrated in the sectional view of Figure 1, this corresponds to a top-to-bottom increasing doping concentration profile for these first lateral current sub-spreading layers, which provides the technical benefit that the upper first lateral current sub-spreading layers with relatively lower doping concentrations will effectively mitigate their influence on the electric field at the surface of the device layer between adjacent active doping regions. Preferably, the first lateral current sub-spreading layers exhibit a progressive decrease in thickness along a direction from a side of the first lateral current sub-spreading layers away from the semiconductor substrate layer to a side of the first lateral current sub-spreading layers towards the semiconductor substrate layer. As illustrated in the sectional view of Figure 1, this corresponds to a top-to-bottom decreasing thickness profile for these first lateral current sub-spreading layers. The structural advantage lies in the enhanced reverse breakdown voltage characteristics provided by the thicker upper first lateral current sub-spreading layers.

In other embodiments, the second lateral current spreading layer 1301 has a plurality of second lateral current sub-spreading layers in a through-thickness direction of the second lateral current spreading layer 1301, enabling a zoned doping concentration distribution in the second lateral current spreading layer 1301. Preferably, the second lateral current sub-spreading layers exhibit a progressive decrease in doping concentration along a direction from a side of the second lateral current sub-spreading layers away from the semiconductor substrate layer to a side of the second lateral current sub-spreading layers towards the semiconductor substrate layer. As illustrated in the sectional view of Figure 1, the doping concentrations of these second lateral current sub-spreading layers decrease from top to bottom. This configuration provides the technical benefit that the upper second lateral current sub-spreading layers with relatively higher doping concentrations will effectively contribute to reducing the specific on-resistance. Preferably, the second lateral current sub-spreading layers exhibit a progressive decrease in thickness along a direction from a side of the second lateral current sub-spreading layers away from the semiconductor substrate layer to a side of the second lateral current sub-spreading layers towards the semiconductor substrate layer. As illustrated in the sectional view of Figure 1, this corresponds to a top-to-bottom decreasing thickness profile for these second lateral current sub-spreading layers. The structural advantage lies in the reduction of specific on-resistance achieved by the thicker upper second lateral current sub-spreading layers.

In the embodiment, the second lateral current spreading layer 1301 is adjacent to the bottom surface of the active doped regions 1302. That is to say, the second lateral current spreading layer 1301 is adjacent to the surface of the active doped regions 1302 that faces toward the semiconductor substrate layer. Similarly, the first lateral current spreading layer 120 is adjacent to the bottom surfaces of the second lateral current spreading layer 1301. In other words, the first lateral current spreading layer 120 is adjacent to the surface of the second lateral current spreading layer 1301 that faces toward the semiconductor substrate layer.

In other embodiments, the second lateral current spreading layer and the bottom surface of the active doped regions are spaced apart by a certain distance. For example, the distance between the second lateral current spreading layer and the active doped regions is less than or equal to 2 µm. The first lateral current spreading layer and the second lateral current spreading layer are spaced apart by a certain distance. For example, the distance between the first lateral current spreading layer and the second lateral current spreading layer is less than or equal to 2 µm.

In the embodiment, the power semiconductor device is configured as a vertical metal-oxide-semiconductor field-effect transistor. The power semiconductor device further includes a gate structure 140 disposed on an upper surface of a portion of the device layer 130, and flanked by the active doped regions 1302 serving as well regions, and source regions 1303 within the well regions, the source regions 1303 has a same conductivity type as the drift layer 110. The gate structure 140 includes a gate dielectric layer 1401 and a gate electrode layer 1402.

Referring to Figure 1, the device layer 130 further includes ohmic contact layers 1304 disposed within partial active doped regions 1302, and a JFET region 1305 disposed at the bottom of the gate structure 140 between adjacent active doped regions 1302 and between adjacent second lateral current spreading layers 1301. The first lateral current spreading layer 120 is positioned below the second lateral current spreading layers 1301 and the JFET region 1305.

In other embodiments, referring to Figure 2, the power semiconductor device is configured as a vertical metal-oxide-semiconductor field-effect transistor. Herein, the power semiconductor device further includes a gate structure 170, flanked by the active doped regions 1302 serving as well regions, and source regions 1303 within the well regions, the source regions 1303 has a same conductivity type as the drift layer. The power semiconductor device in Figure 2 differs from the power semiconductor device in Figure 1 in that the gate structure 170 is positioned in the device layer between adjacent active doped regions 1302 and between adjacent second lateral current spreading layers 1301. The gate structure 170 also includes a gate dielectric layer 1702 and a gate electrode layer 1701.

Referring to Figure 2, the power semiconductor device further includes an additional doped region 1306 between the gate structure 170 and the first lateral current spreading layer 120. The additional doped region 1306 has a conductive type opposite to that of the first lateral current spreading layer 120 and the additional doped region 1306 has a doping concentration higher than that of the drift layer 110. For example, when the first lateral current spreading layer 120 exhibits N-type conductivity, the additional doped region 1306 exhibits P-type conductivity.

Space charge regions are formed at the interfaces between the additional doped region 1306 and the first lateral current spreading layer 120, as well as the additional doped region 1306 and the second lateral current spreading layer 1301. When multiple gate structures 170 are implemented, the space charge regions beneath different gate structures 170 overlap, effectively shielding the electric field intensity at the gate dielectric layers 1702, thereby reducing their field strength.

In other embodiments, the power semiconductor device is configured as an insulated-gate bipolar transistor. Herein, the active doped regions serve as well regions, and the power semiconductor device further includes an emitter region disposed within each of the well regions, the emitter region has a same conductivity type as the drift layer.

Another embodiment of the disclosure provides a method of preparing a power semiconductor device. In the method, a semiconductor substrate layer is provided; and a drift layer, a first lateral current spreading layer and a device layer stacked in a bottom-to-top configuration are formed on the semiconductor substrate layer. Herein, the first lateral current spreading layer has a same conductivity type as the drift layer but a higher doping concentration than the drift layer. The device layer includes a plurality of active doped regions spaced laterally and a second lateral current spreading layer disposed between the active doped regions and portions of the first lateral current spreading layer, without overlapping projections from the second lateral current spreading layer and the device layer between adjacent active doped regions in a direction perpendicular to a surface of the semiconductor substrate layer. The second lateral current spreading layer has a same conductivity type as the first lateral current spreading layer and the second lateral current spreading layer has a higher doping concentration than the drift layer.

In one embodiment, the step of forming the drift layer, the first lateral current spreading layer and the device layer stacked in a bottom-to-top configuration on the semiconductor substrate layer includes forming the drift layer, the first lateral current spreading layer and an initial device layer stacked in a bottom-to-top configuration on the semiconductor substrate layer; forming the plurality of active doped regions spaced laterally in partial regions of the initial device layer; and forming the second lateral current spreading layer in the initial device layer between the active doped regions and portions of the first lateral current spreading layer, so that the initial device layer constitutes the device layer.

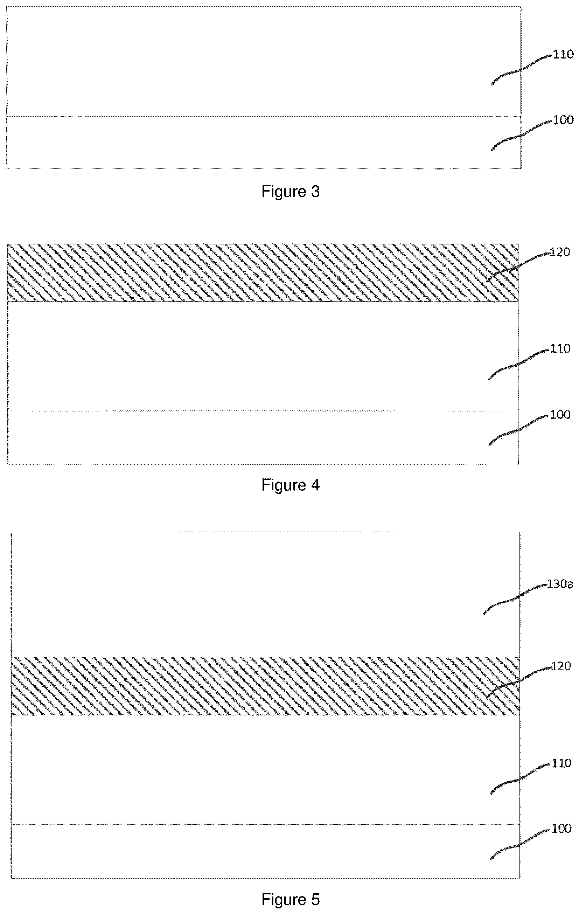

The process of preparing a power semiconductor device will now be described in details with reference to Figures 3 to 11.

Starting from Figures 3 to 5, a drift layer 110, a first lateral current spreading layer 120, and an initial device layer 130a are stacked in a bottom-to-top configuration on the semiconductor substrate layer 100.

The initial device layer 130a shares a same conductivity type as the drift layer 110. In one embodiment, the drift layer 110 exhibits N-type conductivity, and the initial device layer 130a correspondingly exhibits N-type conductivity.

The initial device layer 130a has a doping concentration lower than that of the first lateral current spreading layer and lower than that of the second lateral current spreading layer.

In one embodiment, the doping concentration of the initial device layer 130a ranges from 1×10¹⁵ to 1×10¹⁷ atom/cm³. The doping concentration of the drift layer 110 ranges from 1×10¹⁵ to 1×10¹⁷ atom/cm³.

In the embodiment, when forming the drift layer 110, the first lateral current spreading layer 120 and the initial device layer 130a stacked in a bottom-to-top configuration on the semiconductor substrate layer 100, as shown in Figures 3 to 5, the drift layer 110 is epitaxially grown on the semiconductor substrate layer 100; the first lateral current spreading layer 120 is epitaxially grown on a surface of the drift layer 110 away from the semiconductor substrate layer 100; and the initial device layer 130a is epitaxially grown on a surface of the first lateral current spreading layer 120 away from the drift layer 110.

In an alternative embodiment, when forming the drift layer, the first lateral current spreading layer and the initial device layer stacked in a bottom-to-top configuration on the semiconductor substrate layer, an initial drift layer is epitaxially grown on the semiconductor substrate layer; the first lateral current spreading layer is formed by ion implantation into a partial thickness of the initial drift layer, so that the initial drift layer below the first lateral current spreading layer constitutes the drift layer; and the initial device layer is epitaxially grown on a surface of the first lateral current spreading layer away from the drift layer.

In an alternative embodiment, when forming the drift layer, the first lateral current spreading layer and the initial device layer stacked in a bottom-to-top configuration on the semiconductor substrate layer, an initial drift layer is epitaxially grown on the semiconductor substrate layer; a first initial lateral current spreading layer is formed by ion implantation into a partial thickness of the initial drift layer; and the initial device layer is formed by ion implantation into a partial thickness of the first initial lateral current spreading layer, so that the first initial lateral current spreading layer below the initial device layer constitutes the first lateral current spreading layer, and the initial drift layer below the first lateral current spreading layer constitutes the drift layer. In this case, the conductivity type of the conductive ions implanted into a partial thickness of the first initial lateral current spreading layer for formation of the initial device layer is opposite to that of the conductive ions implanted into a partial thickness of the initial drift layer for formation of the first initial lateral current spreading layer. Accordingly, a portion of the conductive ions implanted into a partial thickness of the initial drift layer for formation of the first initial lateral current spreading layer can be neutralized by the conductive ions implanted into a partial thickness of the first initial lateral current spreading layer for formation of the initial device layer.

In an alternative embodiment, when forming the drift layer, the first lateral current spreading layer and the initial device layer stacked in a bottom-to-top configuration on the semiconductor substrate layer, the drift layer is epitaxially grown on the semiconductor substrate layer; a first initial lateral current spreading layer is epitaxially grown on a side of the drift layer away from the semiconductor substrate layer; and the initial device layer is formed by ion implantation into a partial thickness of the first initial lateral current spreading layer, so that the first initial lateral current spreading layer below the initial device layer constitutes the first lateral current spreading layer. In this case, the conductive ions implanted into the initial device layer and the conductive ions in the first initial lateral current spreading layer have opposite conductivity types. Accordingly, a portion of the conductive ions present in the first initial lateral current spreading layer can be neutralized by the conductive ions implanted into a partial thickness of the first initial lateral current spreading layer for formation of the initial device layer compensate.

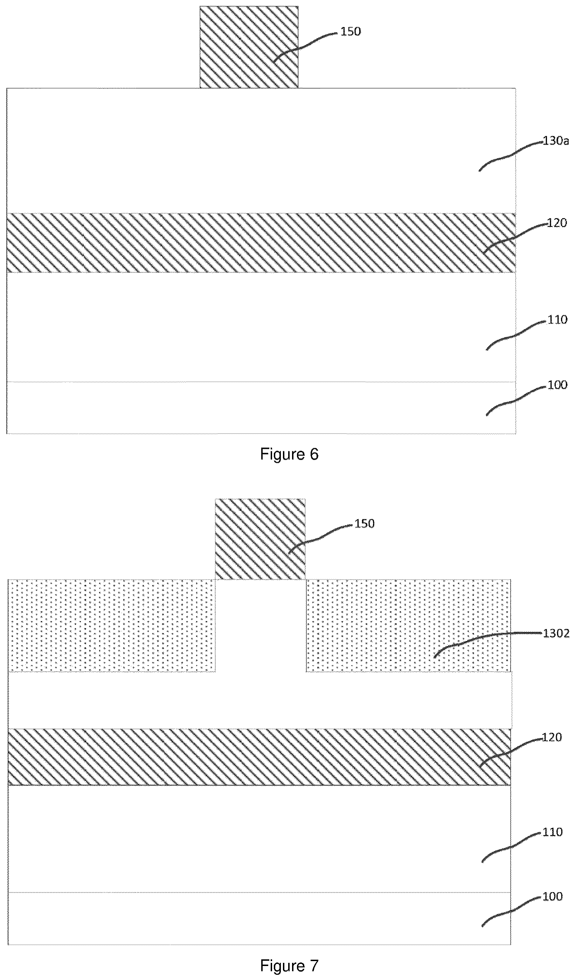

As shown in Figure 7, a plurality of spaced laterally active doped regions 1302 are formed in partial regions of the initial device layer 130a.

The active doped regions 1302 maintain a certain longitudinal distance from the first lateral current spreading layer 120, with the active doped regions 1302 and the first lateral current spreading layer 120 being spaced apart. The conductivity type of the active doped regions 1302 is opposite to both the conductivity type of the initial device layer 130a and the conductivity type of the drift layer.

The initial device layer 130a exposes its top surface. The top surface of the initial device layer 130a is flush with the top surfaces of the active doped regions 1302.

In the embodiment, before formation of the active doped regions 1302, as shown in Figure 6, a mask layer 150 is formed on a surface of a portion of the initial device layer 130a. As shown in Figure 7, active doped regions 1302 are formed in the initial device layer 130a by using the mask layer 150 as mask.

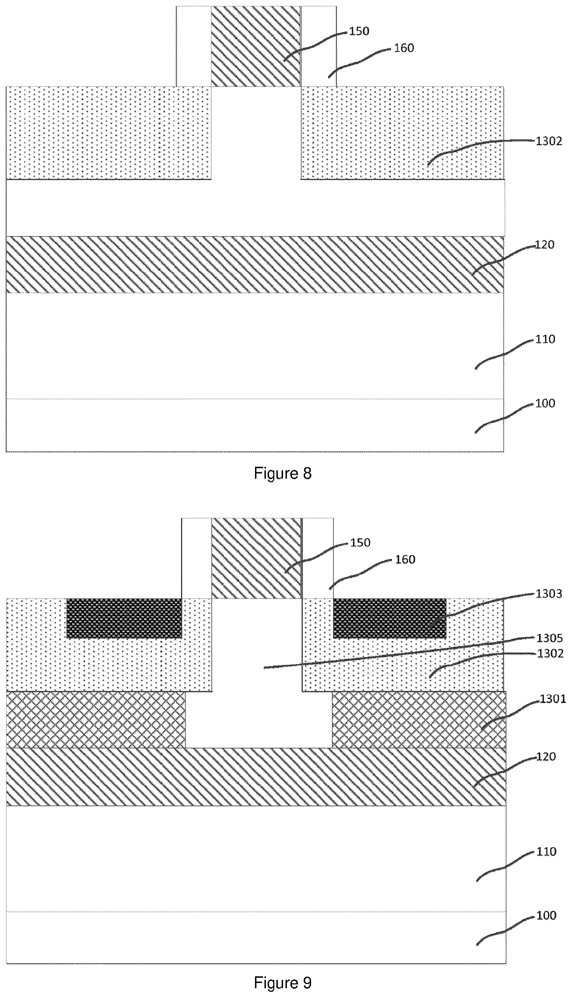

Turning to Figure 8, after formation of the active doped regions 1302 in the initial device layer 130a by using the mask layer 150 as mask, spacers 160 are formed on sidewall surfaces of the mask layer 150, and the spacers 160 cover partial surfaces of the active doped regions 1302.

The spacers 160 are made of a material containing silicon oxide (SiO₂) or silicon nitride (Si₃N₄).

In one embodiment, each of the spacers 160 has a width ranging from 0.1 µm to 2 µm, especially 0.1 µm, 0.5 µm, 0.8 µm, 1 µm, 1.5 µm or 2 µm.

Referring to Figure 9, a second lateral current spreading layer 1301 is formed in the initial device layer 130a between the active doped regions 1302 and portions of the first lateral current spreading layer 120.

Exemplarily, the second lateral current spreading layer 1301 is formed between the active doped regions 1302 and portions of the first lateral current spreading layer 120 by using the spacers 160 and the mask layer 150 as mask.

The process for forming the second lateral current spreading layer 1301 in the initial device layer 130a between the active doped regions 1302 and portions of the first lateral current spreading layer 120 may employ an ion implantation process.

The spacers 160 and the mask layer 150 function to define the position of the second lateral current spreading layer 1301. By utilizing the spacers 160 to achieve self-aligned ion implantation of the second lateral current spreading layer 1301, this layer is precisely positioned beneath the active doped regions 1302 without affecting the JFET region. Consequently, the electric field intensity at the surface of the JFET region can remain lower, avoiding degradation of the reverse breakdown performance and reliability of the power semiconductor device.

Since the self-aligned ion implantation of the second lateral current spreading layer 1301 through the spacers 160 does not increase the doping concentration of the JFET region, the pinch-off effect of the JFET region remains unaffected by the second lateral current spreading layer 1301. This enables a lower pinch-off voltage, thereby reducing the gate-drain capacitance and switching losses.

The active doped regions 1302 function as well regions, and further include source regions 1303 formed within the active doped regions 1302 by using the spacers 160 and the mask layer 150 as mask. The source regions 1303 have a conductivity type opposite to that of the active doped regions 1302.

It should be noted that, in the embodiment, the spacing between adjacent second lateral current spreading layers 1301 is greater than that between adjacent active doped regions 1302, and the lateral dimensions of the second lateral current spreading layers 1301 are smaller than those of the active doped regions 1302.

In other embodiments, masks with different dimensions may be employed to make the lateral dimensions of the second lateral current spreading layers equal to those of the active doped regions.

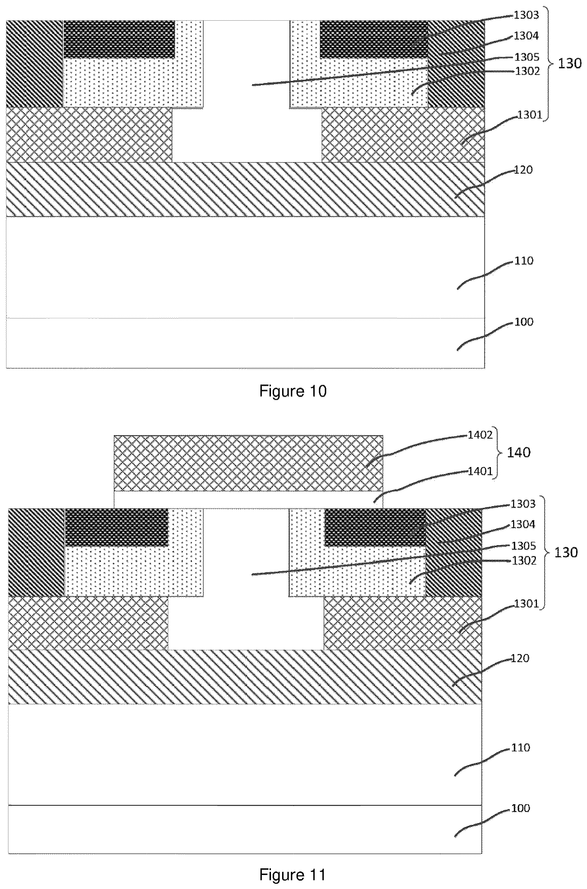

Referring to Figure10, after formation of the second lateral current spreading layers 1301 and the source regions 1303, the mask layer 150 and the spacers 160 are removed.

As shown in Figure 10, ohmic contact layers 1304 are formed in partial active doped regions 1302. Herein, the ohmic contact layers 1304 has a same conductivity type as the active doped regions 1302, and the ohmic contact layers 1304 has a higher doping concentration than the active doped regions 1302.

The device layer located at the bottom of the gate structure 140 between adjacent active doped regions 1302 and between adjacent second lateral current spreading layers 1301 constitutes a JFET region 1305. The first lateral current spreading layer 120 is positioned below the second lateral current spreading layers 1301 and the JFET region 1305.

Referring to Figure 11, a gate structure 170 is formed on a portion of the surface of the device layer, with the active doped regions 1302 on both sides of the gate structure 170, serving as well regions.

It should be noted that, in the embodiment, the active doped regions are formed first, followed by the formation of the second lateral current spreading layer. In alterative embodiments, the second lateral current spreading layer may be formed prior to the active doped regions.

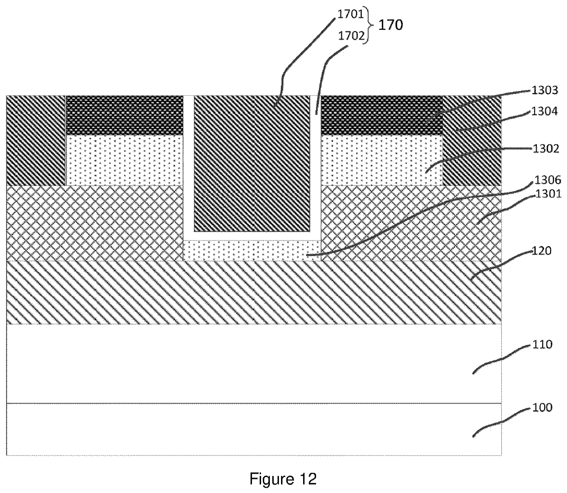

A further embodiment of the disclosure provides a method of preparing a power semiconductor device. Referring to Figure 12, a schematic diagram derived from Figure 10, a gate structure 170 is formed in a device layer between adjacent active doped regions 1302 and between adjacent second lateral current spreading layers 1301. The gate structure 170 also includes a gate dielectric layer 1702 and a gate electrode layer 1701. A source region 1303 is adjacent to the gate structure 170.

Regarding the drift region resistance in the prior art, when electrons flow out of the JFET region and enter the drift region, they are not uniformly distributed. Instead, electron crowding occurs in the top region, leading to an increase in on-resistance. In contrary, the present application provides advantageous solutions, which can optimize these regions to suppress issues such as degradation in breakdown voltage and increased leakage current while minimizing specific on-resistance without compromising other key performance parameters or reliability.

It can be understood that the above embodiments are merely illustrative examples provided for clarity and are not intended to limit the scope of implementations. For those of ordinary skill in the art, other variations or modifications in different forms may be made based on the above description. It is neither necessary nor possible to exhaustively list all possible implementations. Nevertheless, any obvious variations or modifications derived therefrom shall remain within the scope of the disclosure.

## Claims

1. A power semiconductor device, **characterized by** comprising:
a semiconductor substrate layer;
a drift layer disposed on a side of the semiconductor substrate layer;
a first lateral current spreading layer disposed on a surface of the drift layer away from the semiconductor substrate layer, the first lateral current spreading layer having a same conductivity type as the drift layer and a higher doping concentration than the drift layer; and
a device layer disposed on a surface of the first lateral current spreading layer away from the drift layer, wherein the device layer comprises:
a plurality of active doped regions spaced laterally; and
a second lateral current spreading layer disposed between the active doped regions and portions of the first lateral current spreading layer, without overlapping projections from the second lateral current spreading layer and the device layer between adjacent active doped regions in a direction perpendicular to a surface of the semiconductor substrate layer, the second lateral current spreading layer having a same conductivity type as the first lateral current spreading layer and a higher doping concentration than the drift layer.

2. The power semiconductor device according to claim 1, **characterized in that** the doping concentration of the first lateral current spreading layer is either lower than, or higher than or equal to the doping concentration of the second lateral current spreading layer,
wherein preferably the doping concentration of the first lateral current spreading layer ranges from 0.01 to 1 times the doping concentration of the second lateral current spreading layer,
wherein preferably the doping concentration of the first lateral current spreading layer ranges from 2 to 5000 times a doping concentration of the drift layer, and
wherein the doping concentration of the second lateral current spreading layer ranges from 2 to 5000 times the doping concentration of the drift layer.

3. The power semiconductor device according to claim 1 or 2, **characterized in that** the second lateral current spreading layer has a thickness either less than, or greater than or equal to a thickness of the first lateral current spreading layer,
wherein preferably the thickness of the second lateral current spreading layer ranges from 0.2 to 5 times the thickness of the first lateral current spreading layer,
wherein preferably the thickness of the first lateral current spreading layer ranges from 0.1 µm to 10 µm, and
wherein preferably the thickness of the second lateral current spreading layer ranges from 0.1µm to 10 µm.

4. The power semiconductor device according to claim 1, **characterized in that** the first lateral current spreading layer has a plurality of first lateral current sub-spreading layers in a through-thickness direction of the first lateral current spreading layer,
wherein preferably the first lateral current sub-spreading layers exhibit a progressive increase in doping concentration along a direction from a side of the first lateral current sub-spreading layers away from the semiconductor substrate layer to a side of the first lateral current sub-spreading layers towards the semiconductor substrate layer, and
wherein preferably the first lateral current sub-spreading layers exhibit a progressive decrease in thickness along a direction from the side of the first lateral current sub-spreading layers away from the semiconductor substrate layer to the side of the first lateral current sub-spreading layers towards the semiconductor substrate layer.

5. The power semiconductor device according to claim 1, **characterized in that** the second lateral current spreading layer has a plurality of second lateral current sub-spreading layers in a through-thickness direction of the second lateral current spreading layer,
wherein preferably the second lateral current sub-spreading layers exhibit a progressive decrease in doping concentration along a direction from a side of the second lateral current sub-spreading layers away from the semiconductor substrate layer to a side of the second lateral current sub-spreading layers towards the semiconductor substrate layer, and
wherein preferably the second lateral current sub-spreading layers exhibit a progressive decrease in thickness along a direction from the side of the second lateral current sub-spreading layers away from the semiconductor substrate layer to the side of the second lateral current sub-spreading layers towards the semiconductor substrate layer.

6. The power semiconductor device according to claim 1, **characterized in that** the power semiconductor device is configured as a vertical metal-oxide-semiconductor field-effect transistor,
wherein the power semiconductor device further comprises: a gate structure flanked by the active doped regions serving as well regions; and a source region disposed within each of the well regions, the source region having a same conductivity type as the drift layer, and
wherein the gate structure is disposed either on an upper surface of a portion of the device layer, or in the device layer between adjacent active doped regions and between adjacent second lateral current spreading layers.

7. The power semiconductor device according to claim 1, **characterized in that** the power semiconductor device is configured as an insulated-gate bipolar transistor, wherein the active doped regions serve as well regions, and wherein the power semiconductor device further comprises an emitter region disposed within each of the well regions, the emitter region having a same conductivity type as the drift layer.

8. A method of preparing a power semiconductor device, **characterized by** comprising:
providing a semiconductor substrate layer; and
forming a drift layer, a first lateral current spreading layer and a device layer stacked in a bottom-to-top configuration on the semiconductor substrate layer, the first lateral current spreading layer having a same conductivity type as the drift layer and a higher doping concentration than the drift layer, wherein the device layer comprises a plurality of active doped regions spaced laterally; and a second lateral current spreading layer disposed between the active doped regions and portions of the first lateral current spreading layer, without overlapping projections from the second lateral current spreading layer and the device layer between adjacent active doped regions in a direction perpendicular to a surface of the semiconductor substrate layer, the second lateral current spreading layer having a same conductivity type as the first lateral current spreading layer and a higher doping concentration than the drift layer.

9. The method according to claim 8, **characterized in that** forming the drift layer, the first lateral current spreading layer and the device layer stacked in a bottom-to-top configuration on the semiconductor substrate layer comprises:
forming the drift layer, the first lateral current spreading layer and an initial device layer stacked in a bottom-to-top configuration on the semiconductor substrate layer;
forming the plurality of active doped regions spaced laterally in partial regions of the initial device layer; and
forming the second lateral current spreading layer in the initial device layer between the active doped regions and portions of the first lateral current spreading layer, so that the initial device layer constitutes the device layer.

10. The method according to claim 9, **characterized by** further comprising:
forming a mask layer on a surface of a portion of the initial device layer before formation of the active doped regions;
forming the active doped regions in the initial device layer by using the mask layer as mask;
forming spacers on sidewall surfaces of the mask layer after formation of the active doped regions in the initial device layer by using the mask layer as mask, wherein the spacers cover partial surfaces of the active doped regions;
forming the second lateral current spreading layer between the active doped regions and the portions of the first lateral current spreading layer by using the spacers and the mask layer as mask; and
removing the mask layer and the spacers after formation of the second lateral current spreading layer.

11. The method according to claim 10, **characterized in that** the active doped regions serve as well regions; and the method further comprises: before removal of the mask layer and the spacers, forming a source region within each of the active doped regions by using the spacers and the mask layer as mask.

12. The method according to claim 10, **characterized in that** each of the spacers has a width ranging from 0.1 µm to 2 µm.

13. The method according to claim 9, **characterized in that** forming the drift layer, the first lateral current spreading layer and the initial device layer stacked in a bottom-to-top configuration on the semiconductor substrate layer comprises:
epitaxially growing the drift layer on the semiconductor substrate layer;
epitaxially growing the first lateral current spreading layer on a surface of the drift layer away from the semiconductor substrate layer; and
epitaxially growing the initial device layer on a surface of the first lateral current spreading layer away from the drift layer; or
forming the drift layer, the first lateral current spreading layer and the initial device layer stacked in a bottom-to-top configuration on the semiconductor substrate layer comprises:
epitaxially growing an initial drift layer on the semiconductor substrate layer;
forming the first lateral current spreading layer by ion implantation into a partial thickness of the initial drift layer, wherein the initial drift layer below the first lateral current spreading layer constitutes the drift layer; and
epitaxially growing the initial device layer on a surface of the first lateral current spreading layer away from the drift layer; or
forming the drift layer, the first lateral current spreading layer and the initial device layer stacked in a bottom-to-top configuration on the semiconductor substrate layer comprises:
epitaxially growing an initial drift layer on the semiconductor substrate layer;
forming a first initial lateral current spreading layer by ion implantation into a partial thickness of the initial drift layer; and
forming the initial device layer by ion implantation into a partial thickness of the first initial lateral current spreading layer, wherein the first initial lateral current spreading layer below the initial device layer constitutes the first lateral current spreading layer, and wherein the initial drift layer below the first lateral current spreading layer constitutes the drift layer; or
forming the drift layer, the first lateral current spreading layer and the initial device layer stacked in a bottom-to-top configuration on the semiconductor substrate layer comprises:
epitaxially growing the drift layer on the semiconductor substrate layer;
epitaxially growing a first initial lateral current spreading layer on a side of the drift layer away from the semiconductor substrate layer; and
forming the initial device layer by ion implantation into a partial thickness of the first initial lateral current spreading layer, wherein the first initial lateral current spreading layer below the initial device layer constitutes the first lateral current spreading layer.
